Europäisches Patentamt

European Patent Office

Office européen des brevets

(11) Veröffentlichungsnummer: **0 370 377**
**A2**

## (12) EUROPÄISCHE PATENTANMELDUNG

(21) Anmeldenummer: 89121169.0

(22) Anmeldetag: 16.11.89

(51) Int. Cl.5: **G01V 3/10**

(30) Priorität: 22.11.88 DE 3839386

(43) Veröffentlichungstag der Anmeldung:
**30.05.90 Patentblatt 90/22**

(84) Benannte Vertragsstaaten:
**CH FR GB LI SE**

(71) Anmelder: **SCHALLER-AUTOMATION**
**Industrielle Automationstechnik KG**
**Industriering 14**
**D-6653 Blieskastel(DE)**

(72) Erfinder: **Schaller, Werner, Dipl.-Ing.**
**Industriering 14**
**D-6653 Blieskastel(DE)**
Erfinder: **Neumeier, Kurt, Prof.**
**Am Beckerswäldchen 8**
**D-6660 Zweibrücken-Ixheim(DE)**

(54) **Induktiver Näherungssensor.**

(57) Die Erfindung bezieht sich auf einen induktiven Näherungsschalter, bei welchem die Veränderung des Feldlinienverlaufes eines magnetischen Wechselfeldes beim Annähern eines den Feldverlauf beeinflussenden Körpers zur Erzeugung eines Meldesignals benutzt wird.

Das Wechselfeld wird mittels einer Spule erzeugt. Eine besondere Aufnehmerspule wird von unterschiedlichen magnetischen Wechselflüssen durchsetzt, je nachdem ob in den Wirkungsbereich ferromagnetische oder elektrisch leitende, nicht ferromagnetische Stoffe eingebracht werden.

Fig.2

EP 0 370 377 A2

# Induktiver Näherungssensor

Die Erfindung bezieht sich auf einen induktiven Näherungssensor mit einem aus dem Sensorkopf austretenden magnetischen Wechselfeld, das beim Annähern eines das Magnetfeld beeinflussenden Körpers in seinem Feldlinienverlauf verändert wird, und diese Feldbeeinflussung in einer Auswerteschaltung des Sensors festgestellt und zur Erzeugung eines Meldesignals benutzt wird.

Bei den bekannten induktiven Näherungssensoren werden selbstschwingende bedämpfbare Oszillatoren verwendet, wobei der Sensorkopf aus einem Ferritkern besteht, auf den eine Spule gewickelt ist, die Teil des Oszillators ist. Dem Oszillator wird durch eine elektronische Verstärkerschaltung gerade so viel elektrische Energie zugeführt, daß die im Oszillator selbst auftretenden Schwingungsverluste gedeckt werden und der Oszillator mit Resonanzüberhöhung schwingt. Wird nun in das aus dem Ferritkern des Sensorkopfes austretende magnetische Wechselfeld ein elektrisch leitender Körper eingebracht, so werden in diesem Körper durch das magnetische Wechselfeld elektrische Wirbelströme erzeugt, die dem Oszillator Energie entziehen, so daß die Resonanzüberhöhung der Schwingung zusammenbricht und die Energiezufuhr aus dem Verstärker nicht ausreicht, um die Schwingung aufrechtzuerhalten. Der Abriß der Schwingung wird als Signal für das Vorhandensein eines Körpers im Wechselfeld ausgewertet.

Aus der DE-OS 19 15 044 ist auch ein induktiver Näherungssensor bekanntgeworden, bei dem ebenfalls ein selbstschwingender bedämpfbarer oder zur Schwingung anregbarer Oszillator vorgesehen ist. Dieser Sensor soll entweder auf in das magnetische Wechselfeld eindringende Nichteisenmetallkörper oder auf Eisenmetallkörper ansprechen. Sollen Nichteisenmetallkörper angezeigt werden, so wird der Oszillator so eingestellt, daß er gerade noch nicht schwingt. Die das magnetische Wechselfeld erzeugende Spule ist hier von einem Dämpfungsrohr umgeben. Beim Eindringen des Nichteisenmetallkörpers in das magnetische Wechselfeld sollen die Feldlinien zurückgedrängt werden und über einen kürzeren Weg durch das Dämpfungsrohr zurück zum Spulenkern geleitet werden, wodurch die vorher im Dämpfungsrohr entstandenen Wirbelstromverlusteste verringert werden und der Oszillator zum Schwingen angeregt wird. Sollen Eisenmetallkörper detektiert werden, so wird der Oszillator so eingestellt, daß er gerade schwingt. Kommt der Eisenmetallkörper in den Bereich des magnetischen Wechselfeldes, so wird der magnetische Wechselfeldfluß im Eisenkörper konzentriert, wodurch schwingungsdämpfende Wirbelströme entstehen und die Schwingung damit, wie bei den üblichen bedämpften Näherungssensoren, abreißt.

Nachteilig bei diesem und auch bei allen übrigen bekannten wirbelstrombedämpften induktiven Näherungssensoren ist die erforderliche hohe Güte des Oszillators, und außerdem muß die über die Verstärkerschaltung zugeführte Schwingungsenergie ganz exakt eingehalten werden. Zur Erzielung einer hohen Oszillatorgüte sind eine große Induktivität und eine relativ kleine Kapazität im Oszillatorkreis notwendig, wobei die Induktivität wiederum nur durch eine Spule, die auf einen teuren Ferritkern gewickelt ist, geschaffen werden kann. Auch wird, da die Induktivität bei kleineren Sensoren nicht beliebig groß gemacht werden kann, eine hohe Oszillatorfrequenz entstehen, die in den Bereich nicht frei verfügbarer elektromagnetischer Radiowellen fällt. Ganz besonders kritisch ist die Verstärkerschaltung, da diese nur mit großem Aufwand und riskanten Schaltungstricks einigermaßen temperaturstabil gemacht werden kann, wenn ein nicht allzu geringer Schaltabstand erreicht werden soll. Bei größeren Schaltabständen werden von dem aus dem Sensorkopf austretenden magnetischen Wechselfeld nur die äußeren Feldlinien zur Erzeugung von Wirbelströmen in dem in das Feld eingebrachten Metallkörper herangezogen. Ist die durch den Verstärker zugeführte Energie nur um ein Geringes höher als die geforderte Energiezufuhr, so führt der Energieentzug, der nur aus der in der Resonanzüberhöhung steckenden Energie erfolgen soll, nicht zum Zusammenbruch der Schwingung, und der Schaltabstand des Sensors muß weiter verkürzt werden, damit der Energieentzug ausreicht, die Schwingung zusammenbrechen zu lassen. Die heute erreichbaren Schaltabstände liegen bei den bekannten oszillatorbedämpften Näherungsschaltern bei etwa der Hälfte des Ferritkerndurchmessers am Sensorkopf, wobei die üblichen Schalttoleranzen über +/- 10 % liegen.

Aufgabe der Erfindung ist es, einen induktiven Näherungssensor zu schaffen, bei dem mit einfachen Mitteln große Schaltabstände im Verhältnis zum Sensorkopfdurchmesser mit geringen Toleranzen und vernachlässigbarer Temperaturabhängigkeit erreicht werden.

Die Lösung dieser Aufgabe wird in den Merkmalen des Anspruchs 1 gesehen.

Dadurch, daß zur Erzeugung des magnetischen Wechselfeldes eine von einer Wechselstromquelle gespeiste Felderzeugungsspule vorgesehen ist, kann dieser Wechselstrom einer beliebigen temperaturstabilen und relativ niederfrequennten Wechselstromquelle entnommen werden, und ein temperaturstabiler Oszillator hoher Güte und damit verbundener hoher Oszillatorfrequenz, die in den gesetzlich überwachten Störstrahlungsbereich fällt, ist nicht erforderlich. Da eine Aufnehmerspule im Wirkbereich des das Magnetfeld beeinflussenden Körpers angeordnet ist, die bei Nichtvorhandensein eines Körpers von einem Teil der von der Felderzeugungsspule ausgehenden Feldlinien durchflossen wird, so daß eine Wechselspannung in der Aufnehmerspule induziert wird, und beim Einbringen eines Körpers aus einem elektrisch leitenden, nicht ferromagnetischen Stoff in das magnetische Wechselfeld dieses Feld in seiner geometrischen Form verändert, das heißt die Feldlinien vom Körper abgedrängt oder beim Einbringen eines Körpers aus ferromagnetischem Stoff in den Körper hineingezogen werden, und die in der Aufnehmerspule induzierte Wechselspannung durch die Formänderung des magnetischen Feldes und die damit verbundene Änderung der Kraftliniendichte eine Erhöhung oder Reduzierung erfährt, wird der bisher erforderliche Oszillator hoher Güte durch eine einfache Spule ersetzt, so daß insbesondere auch der teure und für die mechanische Konstruktion schwierige und zerbrechliche Ferritkern entfallen kann. Da die Erhöhung und Reduzierung der in der Aufnehmerspule induzierten Wechselspannung zur Erzeugung eines Signals in einer nachgeschalteten Auswerteschaltung benutzt wird, um das Vorhandensein eines Körpers anzuzeigen, entfällt die sehr temperaturempfindliche Verstärkerschaltung für das Oszillatorsystem, und es wird jetzt nur die durch die geometrische Feldverstärkung bedingte Veränderung der induktiven Spannung in der Aufnehmerspule gemessen, um ein Signal zu erzeugen. Dieser Meßvorgang ist weitgehend temperaturunabhängig und ist wesentlich einfacher zu beherrschen als der von vielen Faktoren beeinflußte und damit bei größeren Schaltabständen nur mit Unsicherheit zu beherrschende Schwingungsabriß oder Schwingungseinsatz des Oszillators. Da die Erhöhung oder Reduzierung der in der Aufnehmerspule induzierten Wechselspannung im Wesentlichen durch die am weitesten nach vorn aus dem Sensor austretenden Feldlinien bewirkt wird, kann der Schaltabstand für die Auslösung des Signals wegen der Einwirkung dieser am weitesten aus dem Sensor austretenden Feldlinien erheblich vergrößert werden. Dadurch, daß die durch die geometrische Formveränderung des magnetischen Wechselfeldes ausgelöste Reduzierung oder Erhöhung der in der Aufnehmerspule induzierten Wechselspannung allein zur Signalauswertung benutzt wird, entfällt auch die bisher erforderliche problematische und präzise Energiezufuhr für die Schwingungserhaltung eines Oszillators.

Dadurch, daß entsprechend den Merkmalen des Anspruchs 2 die Aufnehmerspule konzentrisch zur Felderzeugungsspule so angeordnet ist, daß ein Teil aller möglichen Feldlinien des von der Felderzeugungsspule ausgehenden magnetischen Wechselfeldes sich im Innern der Aufnehmerspule schließt ohne eine Spannung in der Aufnehmerspule zu induzieren, und der andere Teil der aus der Felderzeugungsspule weiter nach außen verlaufenden Feldlinien die Aufnehmerspule symmetrisch zur Sensorlängsachse außen umschließt und dadurch eine Wechselspannung in der Aufnehmerspule erzeugt, wird beim Einbringen des Körpers in den Austrittsbereich der Feldlinien aus der Erzeugungsspule der größtmögliche signalwirksame Teil der nach außen aufweitbaren Feldlinien auch tatsächlich nach außen aufgeweitet, umschließen die Aufnehmerspule jetzt außen und erhöhen die in dieser induzierten Spannung, sofern als Werkstoff für den Körper ein nicht ferromagnetischer, elektrisch leitender Stoff verwendet wird. Wird dagegen ein Körper aus ferromagnetischem Werkstoff in den Austrittsbereich der Feldlinien eingebracht, so werden die Feldlinien in diesen Körper durch seine hohe magnetische Leitfähigkeit hineingezogen, wodurch der größtmögliche Teil der die Aufnehmerspule außen umschließenden Feldlinien zum Innern der Aufnehmerspule hin eingeengt wird, wodurch die in ihr induzierte Spannung reduziert wird.

Durch die konzentrische Anordnung der Spulen wird die in der Aufnehmerspule induzierte Spannung besonders stark erhöht oder reduziert, so daß für die Signalauswertung besonders starke Signale zur Verfügung stehen, so daß eine weitere Vergrößerung des Schaltabstandes möglich ist.

Dadurch, daß vom Gesamtstrom für die Wechselfelderzeugung gemäß Anspruch 3 ein Teilstrom abgezweigt und zur Erzeugung einer Kompensationsspannung benutzt wird, ist beim Einbringen eines Körpers in das Feld die sich aus der Feldveränderung ergebende Differenzspannung als signalwirksame Spannung besonders hoch, so daß die Signalauswertung besonders einfach wird oder der Schaltabstand wiederum vergrößert werden kann.

Zweckmäßigerweise besteht die Aufnehmerspule entsprechend Anspruch 4 aus zwei Aufnehmerteilspulen, die so zueinander und zur Felderzeugungsspule angeordnet sind, daß sie von unterschiedlichen Feldlinienanteilen der Felderzeugungsspule durchflossen werden, so daß in den beiden Aufnehmerteilspulen bei einer durch Einbringen eines Körpers ausgelösten Feldveränderung unterschiedliche Induktionsänderungen auftreten, die zur Signalerzeugung ausgenutzt werden. Durch eine solche Anordnung von zwei Aufnehmerteilspulen ist eine geometrische Anordnung dieser Spulen im magnetischen Wechselfeld besonders günstig möglich nämlich in der Weise, daß die sehr weit von der Erzeugungsspule nach außen verlaufenden Feldlinien im Anordnungsbereich der Spulen sich schließen, so daß beim Einbringen eines Körpers in das Fernfeld besonders die zur Signalerzeugung in den Aufnehmerteilspulen entstehenden Spannungsänderungen wirksam werden.

Zweckmäßigerweise lassen sich gemäß Anspruch 5 die beiden Aufnehmerteilspulen auch elektrisch gegeneinanderschalten, so daß sich die darin induzierten Wechselspannungen ganz oder teilweise kompensieren. Dadurch ändert sich beim Einbringen eines Körpers in das magnetische Wechselfeld der Felderzeugungsspule die aus den Aufnehmerspulen kommende Restspannung relativ stark, so daß eine Signalauswertung vereinfacht wird und der Schaltbstand vergrößert weden kann.

Eine besonders günstige Auswerteschaltung läßt sich mit den Merkmalen des Anspruchs 6 erreichen. Dadurch, daß die Spannungsänderung in der Aufnehmerspule oder in den Aufnehmerteilspulen auf eine schon bei kleinsten Änderungen der induzierten Spannung in der Aufnehmerspule wirksame große Phasenverschiebung zurückgeführt wird, ergibt sich eine sichere und empfindliche Signalauswertung, wodurch der Schaltabstand eines mit einer solchen Auswerteschaltung versehenen induktiven Sensors beachtlich vergrößert werden kann.

Weitere zweckmäßige Ausgestaltungen der Erfindung werden gekennzeichnet durch die Unteransprüche 7 bis 11.

Die Erfindung wird anhand von Ausführungsbeispielen in der Zeichnung näher erläutert, und zwar zeigen:

Fig. 1 die Erzeugungs- u.Aufnehmerspulen eines Näherungssensors mit dem dazugehörigen Feldlinienverlauf in schematisierter Darstellung und

Fig. 2 die Spulenanordnung nach Fig. 1, jedoch mit durch einen nicht ferritischen Körper abgedrängtem Feldlinienverlauf und

Fig. 3 die Spulenanordnung nach Fig. 1, jedoch mit durch einen ferritischen Körper nach innen eingeengtem magnetischem Wechselfeld und

Fig. 4 eine Spulenanordnung aus Felderzeugungsspule und zwei Aufnehmerteilspulen mit Feldlinienleitbechern und

Fig. 5 die Schaltung der Felderzeugungsspule und der beiden Aufnehmerteilspulen und

Fig. 6 eine andere Anordnung der Feldlinienleitbecher mit der Felderzeugungspule mit den Aufnehmerteilspulen und

Fig. 7 Vektordiagramm der Restspannung und den Spannungen aus denen die Restspannung gebildet wurde zur Darstellung der Phasenwinkel und

Fig. 7a eine vergrößerte Darstellung der Vektorenden nach Fig.7 und

Fig. 7b eine vergrößerte Darstellung der Vektorenden nach Fig. 7 , jedoch mit verändertem Phasenwinkel

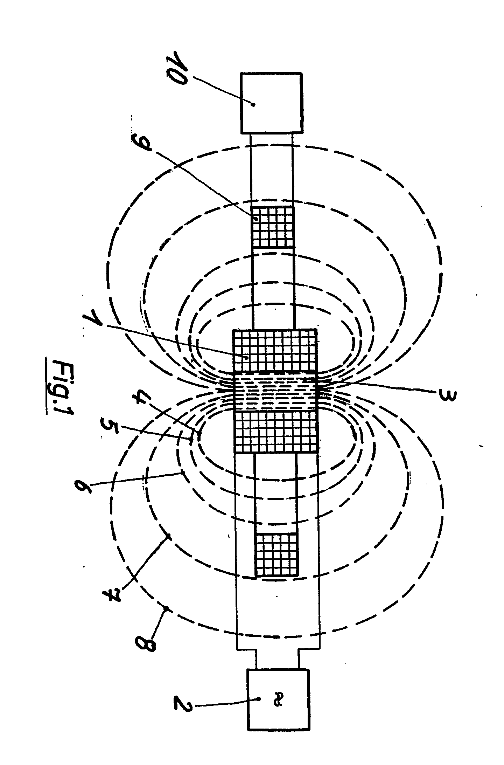

Wie aus der vereinfachenden Darstellung der Fig.1 zu erkennen ist, ist eine Felderzeugungsspule 1 an eine Wechselspannungsquelle 2 angeschlossen, wodurch ein magnetisches Wechselfeld 3 mit den äußeren Feldlinien 4 bis 8 erzeugt wird. Konzentrisch zur Felderzeugungsspule 1 ist eine Aufnehmerspule 9 angeordnet. Die sich außerhalb der Aufnehmerspule 9 schließenden Feldlinien 7 und 8 induzieren in der Aufnehmerspule 9 eine Wechselspannung, während die sich innerhalb der Aufnehmerspule 9 schließenden Feldlinien 4, 5 und 6 nichts zur Induktion der Spannung in der Aufnehmerspule 9 beitragen. Die in der Aufnehmerspule 9 induzierte Wechselspannung wird in der Auswerteschaltung 10 in ein Signal umgeformt.

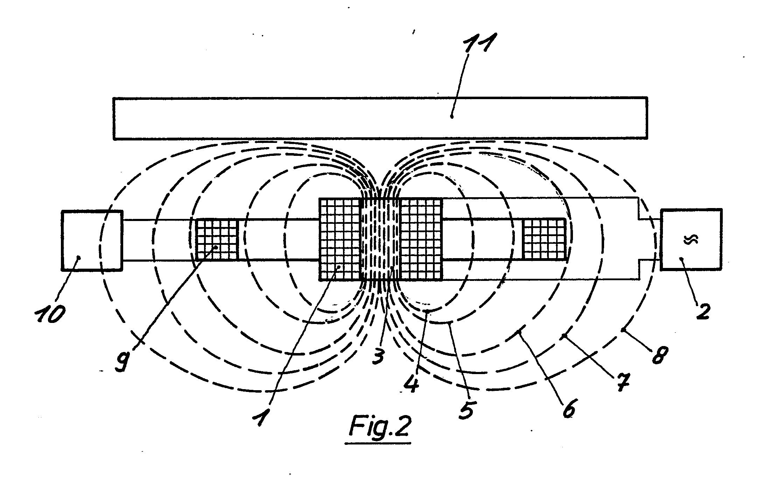

Wie die Fig. 2 zeigt, wird ein Körper 11 aus einem nicht ferritischen, leitenden Werkstoff in das aus der Erzeugungsspule 1 im Sensorkopf austretende magnetische Wechselfeld 4 bis 8 eingebracht, wobei durch die abstoßende Wirkung des Körpers 11 das Feld 4 bis 8 abgedrängt und nach außen aufgeweitet wird. Die abstoßende Wirkung des Körpers 11 beruht bei elektrisch leitendem Werkstoff hauptsächlich auf der reaktiven Wirkung der im Werkstoff erzeugten Wirbelströme. Durch die Aufweitung des Feldes 4 bis 8 wird die Aufnehmerspule 9 jetzt auch von der Feldlinie 6 außen um schlossen, so daß in der Aufnehmerspule 9 jetzt eine Erhöhung der induzierten Wechselspannung auftritt und diese Spannungserhöhung zur Signalauslösung in der Auswerteschaltung 10 benutzt wird.

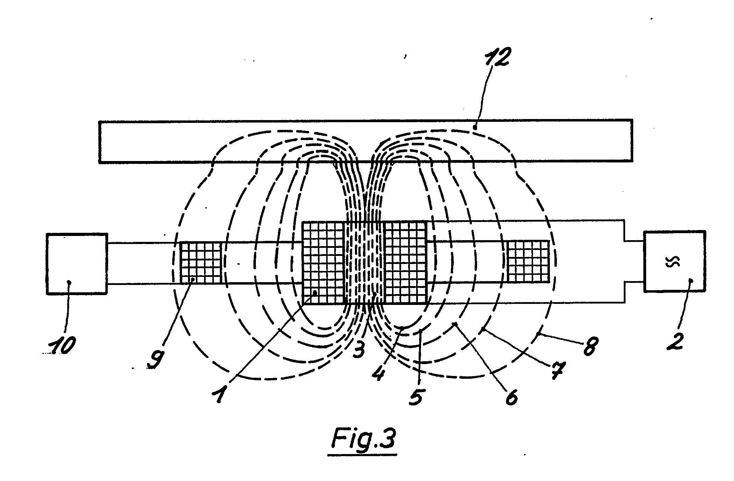

Bei dem Beispiel nach Fig.3 wird im Gegensatz zu Fig.2 jetzt ein Körper 12 aus ferromagnetischem Werkstoff in das Feld 4 bis 8 eingebracht. Dadurch wird nunmehr das Feld 4 bis 8 in den Körper 12 hineingezogen, und dadurch das Feld 4 bis 8 eingeengt. Diese Einengung des Feldes 4 bis 8 wird dadurch bewirkt, daß die Feldlinien 4 bis 8 den kürzeren Weg durch den magnetisch gut leitenden Körper 12 aus ferromagnetischem Werkstoff nehmen. Bei dieser Feldeinengung wandert gegenüber der Fig.1 die Feldlinie 7 in den Innenbereich der Aufnehmerspule 9, wodurch weniger Feldlinien die Aufnehmerspule 9 außen umschließen. Dadurch stehen weniger Feldlinien zur Erzeugung der Induktionsspannung zur Verfügung, so daß die in der Aufnehmerspule 9 induzierte Spannung jetzt geringer wird. Diese Spannungsverringerung wird in der Auswerteschaltung 10 zur Signalerzeugung benutzt.

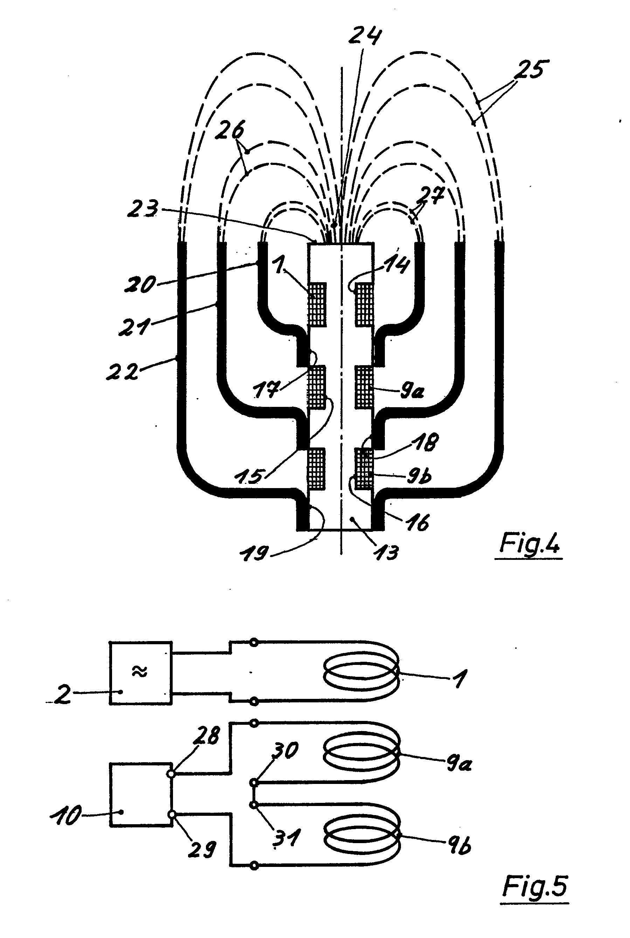

Bei dem Ausführungsbeispiel nach Fig.4 sind Felderzeugungsspule 1 und die beiden Aufnehmerteilspulen 9a und 9b hintereinander auf einem gemeinsamen, magnetisch leitenden Kern 13 angeordnet. Der Kern 13 ist zylindrisch ausgebildet und trägt die Ringnuten 14, 15 und 16, in welche die Spulen 1, 9a und 9b gewickelt sind. Auf die zwischen den Nuten 14, 15 und 16 des zylindrischen Kerns 13 verbleibenden Bunde 17, 18 und 19 sind, jeder Spule zugeordnet, die Feldlinienleitbecher 20, 21 und 22 mit Preßsitz aufgeschoben. Die Feldlinienleitbecher 20 bis 22 liegen konzentrisch ineinander und die Becheröffnungen sind nach vorn zur Ansprechseite des Sensors hin gerichtet.

Bei den Ausführungsbeispielen nach Fig.4 liegt die Felderzeugungsspule 1 vorne und die beiden Aufnehmerteilspulen 9a und 9b in axialer Richtung hintereinander hinter der Felderzeugungsspule 1. Durch die Feldlinienleitbecher 20 bis 22 werden die mittig aus der Felderzeugungsspule 1 austretenden Feldlinien 24 in 3 Feldlinienteilflüsse 25, 26 und 27 aufgeteilt, wobei die am weitesten nach vorne austretenden Feldlinien 25 sich durch den äußeren Becher 22 zur Felderzeugungsspule 1 über den Kern 13 hin schließen und dabei eine Spannung in beiden Aufnehmerteilspulen 9a und 9b induzieren. Die mittleren Feldlinien 26 schließen sich über den mittleren Feldlinienleitbecher 21 und den Kern 13 zur Felderzeugungsspule 1 hin, wobei sie nur in der einen Aufnehmerteilspule 9a eine Spannung induzieren. Die inneren Feldlinien 27 schließen sich über den inneren Feldlinienleitbecher 20 über den Kern 13 zur Felderzeugungsspule 1, ohne auf die Aufnehmerteilspulen 9a und 9b einzuwirken.

Wird nun ein Körper mit feldverdrängender Wirkung in den äußeren Feldlinienbereich 25 eingebracht, so wird das Feld 25 bis 27 nach außen aufgeweitet, wobei ein Teil der mittleren Feldlinien 26 auf den äußeren Feldlinienleitbecher 22 überspringen und jetzt zusätzlich die Aufnehmerteilspule 9b bei ihrem Rückschluß durch den Kern 13 durchfließen. Dadurch wird die in der Aufnehmerteilspule 9b induzierte Spannung erhöht. Die inneren Feldlinien 27 werden beim Einbringen eines das Feld verdrängenden Körpers zwar auch deformiert, aber da sie sowieso schon einen sehr kurzen Rückschlußweg zum inneren Becher 20 haben, nicht auf den mittleren Becher 21 zum Rückschluß abgedrängt.

Die Wirkung auf die Aufnehmerteilspulen 9a und 9b zeigt Fig.5. Die beiden Aufnehmerteilespulen 9a und 9b sind mit ihren Anschlußenden 28 und 29 getrennt an die Auswerteschaltung 10 angeschlossen, während die beiden anderen Anschlußenden 30 und 31 miteinander verbunden sind.

Der Wicklungssinn der Aufnehmerteilspulen 9a und 9b ist gegensinnig gewählt und die Windungszahl so unterschiedlich ausgelegt, daß die Feldlinienflüsse 25 und 26 in den Aufnehmerteilspulen 9a und 9b bei Nichtvorhandensein eines Körpers entgegengerichtete, gleich große Spannungen induzieren, die sich gegeneinander aufheben. Die beim Einbringen eines Körpers in den beiden Aufnehmerteilspulen 9a und 9b auftretende Spannungsveränderung ist gegensinnig und addiert sich positiv durch die vorgenannte Schaltung, so daß die durch den eingebrachten Körper bewirkte Spannungsveränderung für die Signalauswertung voll wirksam wird.

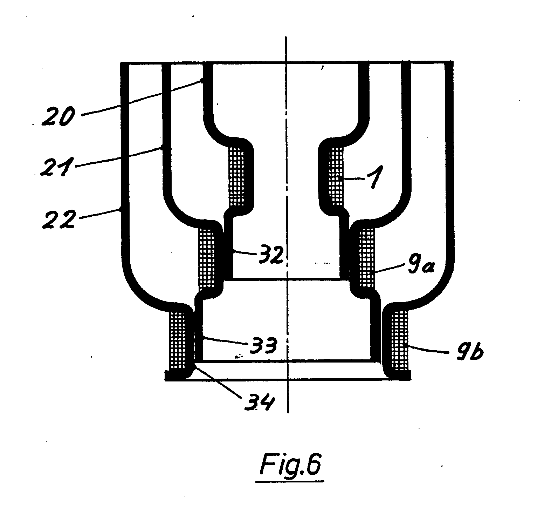

Die Fig.6 zeigt einen in der Herstellung besonders einfachen Sensor nach Fig.4. Die Feldlinienleitbecher 20, 21 und 22 sind an ihren Böden mit im Durchmesser kleineren Rohransätzen 32, 33 und 34 versehen. Der Rohransatz 32 trägt die Felderzeugungsspule 1, während auf den Rohransatz 33 die Aufnehmerteilspule 9a und auf den Rohransatz 34 die Aufnehmerteilspule 9b gewickelt sind. Die Feldlinienleitbecher 20, 21 und 22 werden nach dem Wickeln der Spulen 9a und 9b ineinandergesteckt, so daß die ineinandergepreßten Rohransätze 32, 33 und 34 den Spulenkern bilden.

Ist die in der Aufnehmerspule induzierte Spannungsänderung sehr klein gegen die vorhandene Grundspannung, so ist es einfacher, die Spannungsmessung auf eine, dann ja zeitabhängige Phasenmessung zurückzuführen.

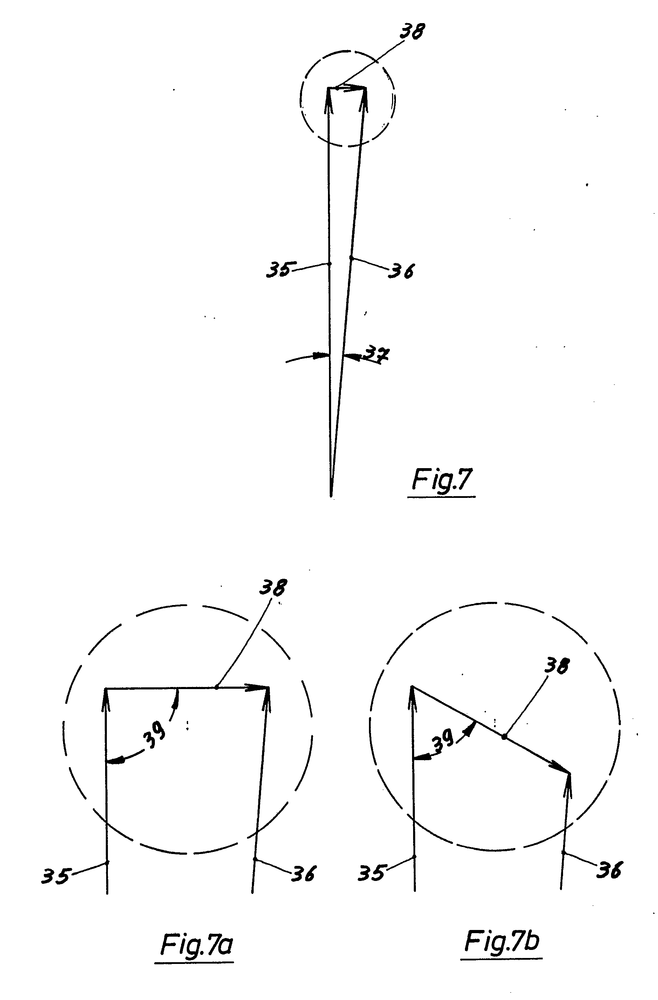

Die Fig.7 zeigt die beiden sich kompensierenden Spannungen 35, z.B. die abgezweigte Teilspannung aus der Felderzeugungsspule 1 und Spannung 36, z.B. die induzierte Spannung aus der Aufnehmerspule 9 und deren kleinen Phasenwinkel 37, sowie die resultierende Differenz als Restspannung 38. Fig. 7a zeigt vergrößert den dabei entstehenden Phasenwinkel 39 zwischen Restspannung 38 und der kompensierenden Spannung 35. Aus der Fig.7b geht deutlich hervor, daß bereits eine, durch Einbringen eines Körpers in das Wechselfeld hervorgerufene, geringfügige Änderung der Spannung 36 in der Aufnehmerspule eine große Änderung des Phasenwinkels 39 auslöst. Diese große Veränderung des Phasenwinkels läßt sich wesentlich genauer messen, als die geringe Veränderung der Spannung 36 der Aufnehmerspule.

## Ansprüche

1. Induktiver Näherungssensor mit einem aus dem Sensorkopf austretenden magnetischen Wechselfeld (3), das beim Annähern eines das Magnetfeld beeinflussenden Körpers in seinem Feldlinienverlauf (4 bis 8) verändert wird, und diese Feldbeeinflussung in einer Auswerteschaltung (10) des Sensors festgestellt und zur Erzeugung eines Meldesignals benutzt wird, **dadurch gekennzeichnet, daß** zur Erzeugung des magnetischen Wechselfeldes eine von einer Wechselstromquelle (2) gespeiste Felderzeugungsspule (1) vorgesehen ist, und eine Aufnehmerspule (9, 9a, 9b) im Wirkbereich des das Magnetfeld (4 bis 8, 25 bis 27) beeinflussenden Körpers (11, 12) angeordnet ist, die bei Nichtvorhandensein eines Körpers von einem Teil der von der Felderzeugungsspule (1) ausgehenden Feldlinien (3, 4 bis 8, 24, 25 bis 27) durchflossen wird, so daß eine Wechselspannung in der Aufnehmerspule (9, 9a, 9b) induziert wird, und beim Einbringen eines Körpers (11) aus einem elektrisch leitenden, nicht ferromagnetischen Stoff in das magnetische Wechselfeld dieses Feld in seiner geometrischen Form verändert, das heißt die Feldlinien vom Körper abgedrängt oder beim Einbringen eines Körpers aus ferromagnetischem Stoff (12) in den Körper hineingezogen werden, und die in der Aufnehmerspule (9,9a,9b) induzierte Wechselspannung durch die Formveränderung des magnetischen Feldes und die damit verbundene Änderung der Kraftliniendichte eine Erhöhung oder Reduzierung erfährt, und diese Veränderung der in der Aufnehmerspule induzierten Spannung zur Erzeugung eines Signals zum Anzeigen des Vorhandenseins eines das Feld beeinflusssenden Körpers (11, 12) in einer nachgeschalteten Auswerteschaltung (10) benutzt wird.

2. Induktiver Näherungssensor nach Anspruch 1, **dadurch gekennzeichnet**, daß die Aufnehmerspule (9) konzentrisch zur Felderzeugungsspule (1) so angeordnet ist, daß ein Teil (4, 5, 6) aller möglichen Feldlinien des von der Felderzeugungsspule (1) ausgehenden magnetischen Wechselfeldes (3) sich im Innern der Aufnehmerspule (9) schließt, ohne eine Spannung in der Aufnehmerspule (9) zu induzieren, und der andere Teil (7, 8) der aus der Felderzeugungsspule (1) weiter nach außen verlaufenden Feldlinien die Aufnehmerspule (9) außen umschließt und dadurch eine Wechselspannung in der Aufnehmerspule erzeugt, wobei beim Einbringen eines Körpers (11) aus einem elektrisch leitenden, nicht ferromagnetischen Stoff in den Austrittsbereich des magnetischen Wechselfeldes (4 bis 8, 24, 25 bis 27) dieses Feld in seiner geometrischen Form verändert, das heißt nach außen aufgeweitet wird oder beim Einbringen eines Körpers (12) aus ferromagnetischem Stoff nach innen eingeengt wird, und die dadurch eintretende Erhöhung oder Reduzierung der in der Aufnehmerspule (9, 9a, 9b) induzierten Wechselspannung zur Erzeugung eines Signals zum Anzeigen eines das Feld beeinflussenden Körpers (11, 12) in einer nachgeschalteten Auswerteschaltung (10) benutzt wird.

3.Induktiver Näherungssensor nach Anspruch 1 oder 2, **dadurch gekennzeichnet**, daß ein in einer festen Relation zum Gesamtstrom für die Felderzeugung in der Felderzeugungsspule stehender Teilstrom abgezweigt und zur Erzeugung einer Kompensationsspannung benutzt wird, die so dimensioniert ist, daß sie die in der Aufnehmerspule (9, 9a, 9b) erzeugte Induktionsspannung ganz oder teilweise kompensiert, und nur die beim Einbringen eines Körpers (11,12) durch die Felderweiterung oder Feldeinengung verursachte Veränderung der zwischen der Aufnehmerspule (9) und der abgezweigten Teilspannung der Felderzeugungsspule (1) vorhandene Differenzspannung zur Signalerzeugung herangezogen wird.

4. Induktiver Näherungssensor nach einem der Ansprüche 1 oder 2, **dadurch gekennzeichnet**, daß die Aufnehmerspule (9) aus zwei Aufnehmerteilspulen (9a, 9b) besteht, die so zueinander und zur Felderzeugungsspule (1) angeordnet sind, daß sie von unterschiedlichen Feldlinienanteilen (4 bis 8, 25 bis 27) der Felderzeugungsspule (1) durchflossen werden, so daß in den beiden Aufnehmerteilspulen (9a, 9b) bei einer durch Einbringen eines Körpers (11, 12) ausgelösten Feldveränderung unterschiedliche Induktionsspannungsänderungen auftreten, die zur Signalerzeugung ausgenutzt werden.

5. Induktiver Näherungssensor nach Anspruch 4, **dadurch gekennzeichnet**, daß die beiden Aufnehmerteilspulen (9a, 9b) elektrisch gegeneinander geschaltet sind, (28, 29, 30, 31) so daß sich die darin induzierten Wechselspannungen, wenn kein Körper in das äußere Magnetfeld eingebracht ist, ganz oder teilweise kompensieren, so daß zur Signalerzeugung nur die Induktionsspannungsänderungen beider Teilspulen (9a, 9b) wirksam werden.

6. Auswerteschaltung für einen induktiven Näherungsschalter nach einem der Ansprüche 3 oder 5, **dadurch gekennzeichnet**, daß die sich kompensierenden Spannungen durch Schaltungsauslegung so gewählt werden, daß zwischen ihnen ein kleiner Phasenwinkel (37) entsteht und daß die verbleibende Restspannung (38) gegen die sich kompensierenden Spannungen (35, 36) als deren Differenz sie gebildet wurde, sehr klein ist, und daß zur Signalerzeugung die Veränderung des Phasenwinkels (39) zwischen Restspannung (38) und einer der sich kompensierenden Spannungen (35, 36) aus denen die Restspannung (38) gebildet wurde zur Signalerzeugung benutzt wird, wenn ein Körper (11, 12) in den Wirkbereich eingebracht wird.

7. Induktiver Näherungssensor nach einem der Ansprüche 1 bis 6, **dadurch gekennzeichnet,** daß die Felderzeugungsspule (1) und die Aufnehmerspule (9) bzw.die Aufnehmerteilspulen (9a, 9b) in axialer Richtung hintereinander auf einen gemeinsamen, einteiligen, magnetisch leitenden Kern (13) gewickelt sind und jede Spule (1, 9a, 9b) von einem Feldlinienleitbecher (20 bis 22) aus magnetisch leitendem Material umschlossen ist, und die Bechermäntel der Feldlinienleitbecher (20 bis 22) konzentrisch ineinander liegen und die Becheröffnungen nach vorn zur Ansprechseite (23) des Sensors hin gerichtet sind.

8. Induktiver Näherungssensor nach Anspruch 7, **dadurch gekennzeichnet**, daß die Felderzeugungsspule (1) zur Ansprechseite (23) des Sensors hin vorne angeordnet ist, während die Aufnehmerspule (9) oder die beiden Aufnehmerteilspulen (9a, 9b) in axialer Richtung nacheinander dahinter angeordnet sind.

9. Induktiver Näherungssensor nach Anspruch 7 und 8, **dadurch gekennzeichnet**, daß als magnetisch leitender Kern (13) ein mit Ringnuten (14 bis 16) für die Aufnahme der Spulen (1,9, 9a, 9b) versehender Rotationskörper dient, auf den die Feldlinienleitbecher ( 20 bis 22) nach Wickeln der Spulen mit Preßsitz auf die zwischen den Spulen vorhandenen Bunde (17 bis 19) des Rotationskörpers (13) aufgeschoben sind.

10. Induktiver Näherungssensor nach Anspruch 7 und 8, **dadurch gekennzeichnet**, daß die Feldlinienleitbecher (20 bis 22) an ihren Böden mit im Durchmesser kleineren Rohransätzen (32 bis 34) versehen sind, auf die die Spulen (1,9, 9a, 9b) aufgewickelt sind und die Feldlinienleitbecher (20 bis 22) nach dem Wickeln der Spulen (1,9,9a, 9b) ineinandergesteckt sind, wobei die ineinandergesteckten Rohransätze (32 bis 34) den Spulenkern (13) bilden.

11. Induktiver Näherungssensor nach einem der Ansprüche 1 bis 10, **dadurch gekennzeichnet**, daß der Mantel des äußeren Feldlinienleitbechers (22) gleichzeitig ein Teilstück eines metallischen, magnetisch gut leitenden Sensoraußenmantels bildet.

12. Induktiver Näherungssensor nach einem der Ansprüche 1 bis 11, **dadurch gekennzeichnet**, daß die in der Auswerteschaltung (10) erkennbare Erhöhung oder Reduzierung der Spannung in der Aufnehmerspule (9) oder in den Aufnehmerteilspulen (9a, 9b) dazu benutzt wird, um durch die Auswerteschaltung (10) zu signalisieren, ob die Spannungsänderung durch Einbringen eines elektrisch leitenden, nicht ferromagnetischen Stoffes (11) oder durch Einbringen eines ferromagnetischen Stoffes (12) ausgelöst wurde.

*Fig.1*

Fig.2

_Fig.3_

_Fig.4_

_Fig.5_

Fig.6

Fig.7

Fig.7a

Fig.7b